# EUROPEAN PATENT SPECIFICATION

(11) **EP 2 766 971 B1**
(45) Date of publication and mention of the grant of the patent: **17.10.2018**
(21) Application number: 12733440.7
(22) Date of filing: 18.06.2012
(51) Int. Cl.: H02H 7/12, H02M 3/158, H02M 1/00, H02M 3/335, H03K 17/18

(54) **POWER CONVERTER SENSE PIN CONTROL ARRANGEMENT**
STEUERUNGSANORDNUNG FÜR EINE LEISTUNGSWANDLER-ERFASSUNGSNADEL
AGENCEMENT DE COMMANDE DE BROCHE DE DÉTECTION D'UN CONVERTISSEUR DE PUISSANCE

(30) Priority: 16.06.2011 GB 201110128
(43) Date of publication of application: 20.08.2014
(73) Proprietor: Texas Instruments (Cork) Limited, Dublin 2 (IE)
(72) Inventor: YOUNG, George, Blackrock Co Dublin (IE); KEOGH, Bernard, Glanmire Co Cork (IE); O'DRISCOLL, Seamus, Cloyne Co Cork (IE)
(74) Representative: Zeller, Andreas
(86) International application number: PCT/EP2012/061607
(87) International publication number: WO 2012/172111

(56) References cited:
- TW-A- 200 901 607
- US-A1- 2011 096 574

## Description

The present invention relates to power converters and power adapter and in particular to integrated circuit controllers for such converters and adapters.

The market for integrated circuit controller device for power converters is extremely cost sensitive: devices which are too expensive simply will not succeed. Accordingly all possible steps must be taken to reduce the cost of such devices. Presently, it is possible to integrate a large number of functions which are required for the control of a power converter into a single device. Clearly, control outputs much be taken from the device to control the external circuitry such as the switching transistors used in the converter, equally feedback signals which enable the device to sense present values of various parameters must be conveyed to the device. Providing a pin on the integrated circuit device package for all such required signals is a significant driver of the overall cost of the device and it is desirable therefore that package pin count is minimised.

To this end, there have been proposals to provide pins of multiple functionalities. For example, a single pin may be used to sense different quantities during different parts of a control cycle. In the arrangement described in United States Patent 7,098,632 a single pin is connected to the mid-point between high and low side drivers. In this way the control device described is able to monitor the converter circuitry for an overcurrent condition by sensing the voltage at the pin during a first time (low side driver on) and also detect the onset of discontinuous conduction in the converter circuitry by sensing the voltage at the pin during a second time (low side driver off, high side driver on). US 2011/096574 relates to a switching power controller and system. < - >.

The present invention in a first aspect thereof seeks to improve upon such a multiple pin use arrangement.

In some low cost device designs, functionality is simply sacrificed in order to save pin count and the lowest cost devices can be rather basic. However it is self evident that the signals on some pins are indispensible. It would seem for example that a power converter controller device must at least provide a control signal for a switching transistor and a sense pin for at least output voltage or output current or current through the switching device itself.

In a basic power converter design, a rectifying diode is used to produce a dc voltage at the output from the switched waveform produced by the regulation stage. Typically schottky diodes are employed for this purpose, It is known that the performance of such a design may be improved by using a synchronous rectifier which takes the form of a switch in place of or in parallel with the diode: the switch is turned on only when the diode would be conducting. Less energy is now wasted in rectification since the switch has a lower forward voltage drop across it when conducting compared to the diode.

Where a switching transistor is used as a synchronous rectifier, it is possible in some topologies to arrange that the switch is turned on by the output stage itself if the control gate of the transistor is wired to a suitable voltage within the circuitry of the stage and no outside control is required. However, it is also known that even better results may be obtained if the synchronous rectifier is controlled more precisely. For < TW 200 901 607 relates to a voltage regulator and related electronic device for sensing an input voltage via a multiplex pin of a linear voltage controller > this reason there are integrated circuit devices available, such as the UCC24610 from Texas Instruments, which comprise a synchronous rectifier controller. Such a device is employed in conjunction with a converter controller device in a separate integrated circuit package. In an isolated design where a regulating stage is on a primary side of a transformer which isolates a rectifying output stage on its secondary side, the synchronous rectifier device may be placed on the secondary side. Clearly, the cost of such a separate device rules it out as a choice for a lowest cost converter design.

The synchronous rectifier control function may be integrated in the same device as the converter controller. An example of such a device is the LM5045 from National Semiconductor; the provision of such functionality adds cost to the controller device, not least in added pin count. Such devices are thus aimed at highly specified converters where the increased cost of providing a larger device in a larger package with a higher pin count may be justified.

The present invention in a second aspect thereof seeks to provide synchronous rectifier control functionality in a lower cost device of restricted pin count.

According to the present invention there is provided apparatus as set forth in the claims.

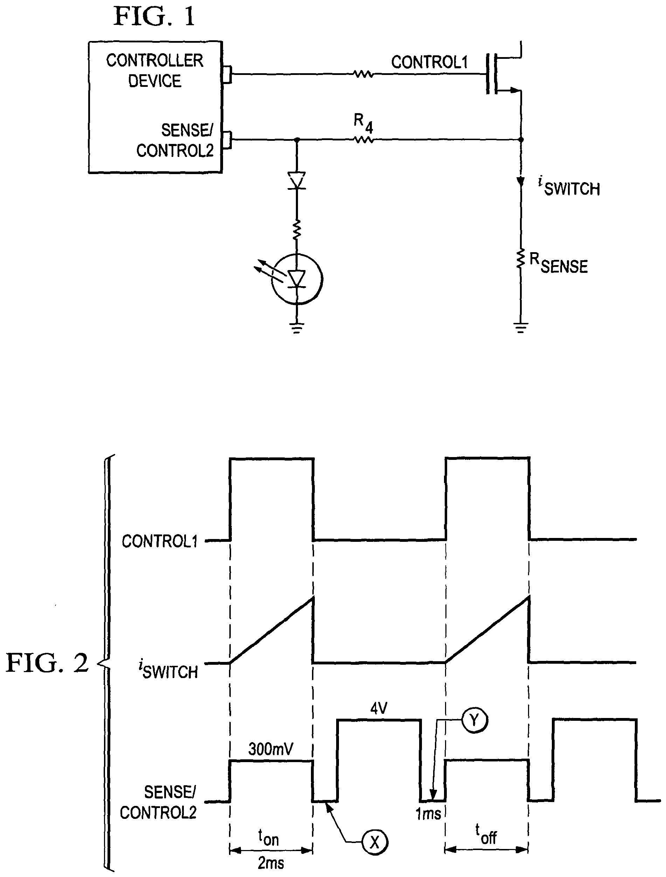

Figure 1 depicts a power converter control device connected to a drive transistor. The transistor is driven from a device pin and controlled such that power to a subsequent rectification stage (not shown) is modulated to provide a specified regulated output. When the transistor is on in addition to transferring power to the rectification stage, current flows through a sense resistor to provide a feedback signal to enable the controller device to perform regulation control. The sense resistor is connected to a pin of the device. It will be appreciated that the sense resistor may be deployed at other places in the converter circuitry for example to sense output current or even configured as a potential divider to sense output voltage.

In all of these case, it is possible to keep the sensed voltage small and where current sensing is involved, as for example in the arrangement of Fig. 1, it is indeed desirable that it be so since the sense resistor should have a low value to avoid undue power dissipation.

Circuit waveforms are shown in Fig. 2 wherefrom it will be observed that when the control signal drive the gate of the transistor to turn it on at time ton, then the sense pin receives a voltage typically in the range up to several hundred mV. For example a current of 1A in 200mR sense resistance would give a sense voltage of 200mV. As mentioned this voltage is sensed at the device pin in order to give feedback to the control arrangement within the device.

The description of the operation of the circuitry thus far could apply to numerous prior art converter arrangements, however it will be observed from Fig 1 that in accordance with the present invention additional circuitry is connected to the device sense pin. The behaviour of the arrangement will now be described. During tₒₙ, the behaviour is as thus far described. However it will be observed that during a portion of t_{off} when the transistor is not driven, the voltage of the drive pin is elevated to a voltage of about 4 V which is sufficient to turn on the light emitting diode of an opto-coupler as shown. The voltage during t_{off} does not come from the external circuit but is generated within the device and multiplexed onto the very same sense pin. This drive voltage to the opto-coupler has no deleterious effect on the rest of the circuit since but a small current is generated through the sense resistor, R1 being made much larger in value than the sense resistor. In any case, the switching transistor is held off by the drive signal on the device pin when the elevated voltage to turn on the opto-coupler is present. Equally, the presence of the sense voltage during ton cannot turn on the opto-coupler since it is too low.

It will be appreciated that the present invention has enable the controller device to provide an additional control/drive signal output without recourse to adding a pin to the device package. Such a signal may usefully serve to drive a slower auxiliary output by peak-detection or average-detection of the pin voltage. Such an auxiliary output could be used for functions such as range switching.

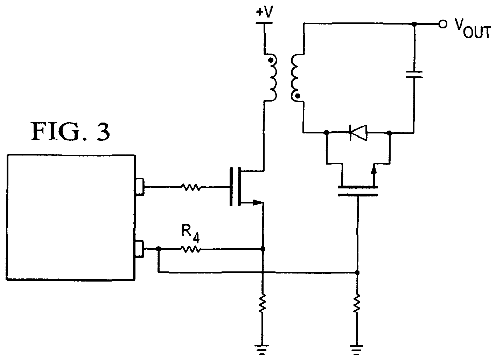

In alternative embodiment of the present invention, the additional output may serve to drive a transistor and such an arrangement is depicted in Fig. 3 which a basic flyback converter is including a switching transistor connected as a synchronous rectifier in parallel with a rectifying diode. It will be observe that the synchronous rectifier is controlled by the drive signal from the device sense pin.

This is a particularly advantageous form of the present invention. It will be recalled that the sense pin drive signal is only available during toff: this is precisely the interval during at least part of which the synchronous rectifier is required to be on. The synchronous rectifier is not required during ton since in a flyback design this is the time that the current will seek to reverse and should be blocked by the diode.

It is well known in the art that a synchronous rectifier may be controlled in a rather sophisticated manner to maximise efficiency and performance. For example, timing may be controlled over several cycles to minimise dead time before the synchronous rectifier is switched on or a zero crossing detector employed to switch off the synchronous rectifier at the precise moment the current seeks to reverse. It may be possible to dispense with the parallel rectifying diode altogether, although in such designs a body diode is usually retained as part of the synchronous rectifier structure. Such advanced designs are implemented for system in which the cost of a more complex controller within its higher pin-out and pin-in requirements may be justified.

An attraction here is that the synchronous rectifier operates directly under control of the primary controller. This controller can predict the time when the synchronous rectifier can be turned off optimally. In discontinuous conduction mode this can be at the stage when current has dropped almost to zero. In continuous-conduction mode ("CCM"), an appropriate guard interval between synchronous rectifier turn off and turn on of the primary FET can be provided. CCM presents very difficult implementation challenge synchronous rectifier controllers with secondary-side sensing, invariably involving some element of cross-conduction (relying on transformer leakage inductance for current limitation). Controlling the synchronous rectifierfrom the primary involves no such issues. Further in critical conduction mode (CrCM) on can choose the synchronous rectifier conduction interval such that a small amount of reverse current flow can be permitted, which assists in obtaining zero-voltage switching of the primary-side FET device.

Nonetheless all of the techniques are valid with the present invention, however since it is envisaged that the present invention will often be used in a low cost controller device, a basic converter is presented as an embodiment. The waveforms associated with this embodiment are as shown in Fig. 2. Due to the minimum feedback available to the controller device, advanced synchronous rectifier control regimes are not implemented, there is for example no attempt to minimise dead time on a per cycle basis. On the other hand, provided the control regime is such that the synchronous rectifier is never on at a time that could permit reversal of current (for example synchronous rectifier action may be suspended if the converter is very lightly loaded and operation in a discontinuous conduct mode is appropriate) then the synchronous rectifier yields an improved performance whenever it is on by virtue of its lower forward voltage drop than the diode. At other times, the diode functions as the sole rectifying device as in a prior art arrangement with no synchronous rectifier.

As an extension of the embodiment as cited, under start-up conditions it is possible for the controller IC to apply a voltage to the pin and measure the current flowing in R4. R4 is typically several orders of magnitude greater than the current sense resistor. Choice of R4 - within bounds set by practical considerations such as pin capacitances, drive requirements etc - can thus be undertaken arbitrarily and this can be used to set control algorithm parameters within the controller, including for example allowed peak/average current ratio.

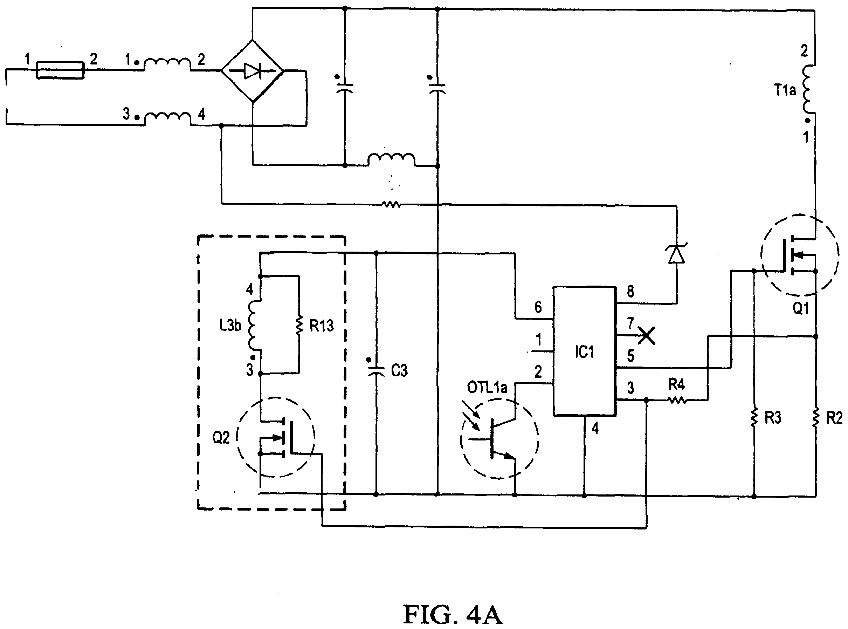

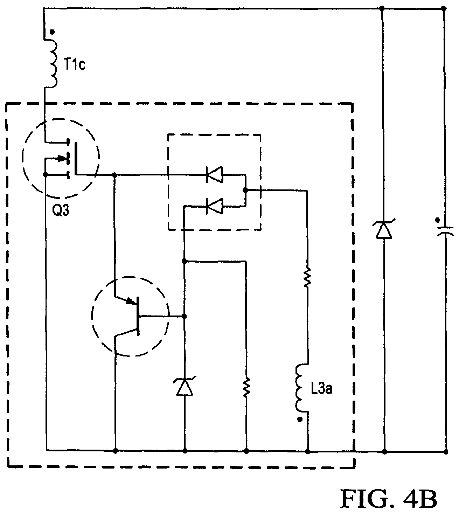

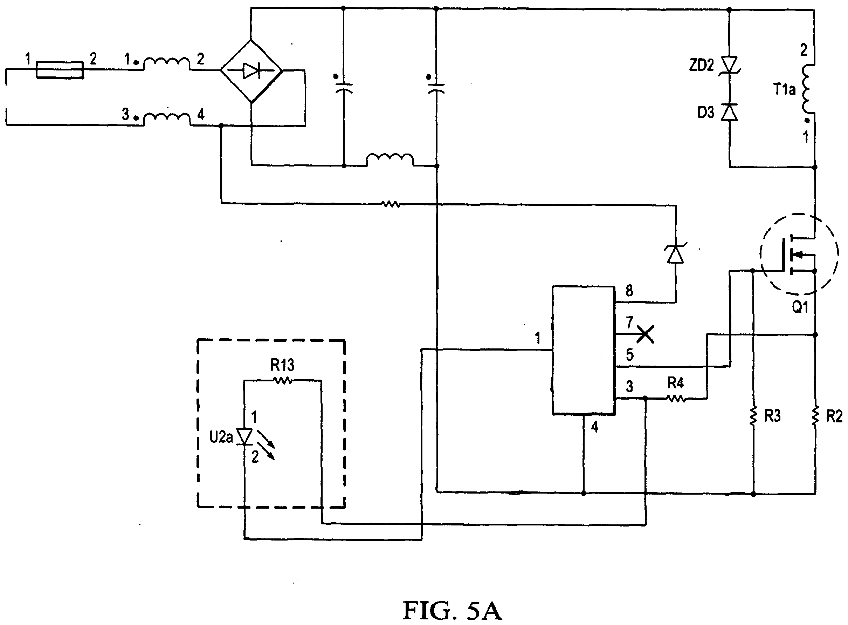

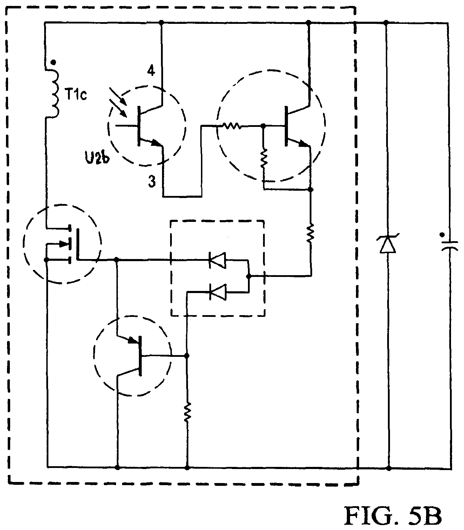

Two further embodiments of the present invention are depicted in Figs. 4 & 5, both of which have isolated rectifying output stages Fig. 4 is a magnetically coupled arrangement and Fig 5 an opto-isolated arrangement. Figure 4 shows the synchronous rectifier fet magnetically driven with a small transformer and figure 5 shows an optocoupler drive with appropriate level translation circuitry.

## Claims

1. A power converter controller device formed as a packaged integrated circuit, the device including:
means for generating a first control signal to control on time of a regulation switching transistor;
a first package pin for connecting the first control signal to the regulation switching transistor in the power converter circuitry;
a second package pin connectable to a sense resistor and coupled to circuitry integrated within the controller device to sense a voltage across the sense resistor when the regulation switching transistor is on, wherein the sense resistor is placed in a current path, the current path being conducting when the regulation switching transistor is on and nonconducting otherwise;
means for generating a second control signal; and
means for coupling the second control signal to the second package pin when the regulation switching transistor is off.

2. A power converter controller as claimed in claim 1 and wherein the second control signal is a control signal for a synchronous rectifier.

3. A power converter controller as claimed in any preceding claim and wherein the second control signal is at an elevated voltage level sufficient to turn on an opto-coupler, the sensed voltage being insufficient so to do.

4. A power converter controller as claimed in any preceding claim and being adapted to sense a voltage across a resistor connected to the second package pin when the second control signal is coupled to the second package pin.

5. A power converter substantially as herein described with reference to the drawings.

## Patentansprüche

1. Leistungswandlersteuervorrichtung, die als ein gekapselter integrierter Schaltkreis gebildet ist, wobei die Vorrichtung Folgendes beinhaltet:
ein Mittel zum Erzeugen eines ersten Steuersignals, um eine Ein-Zeit eines Regelschalttransistors zu steuern;
einen ersten Gehäusestift zum Verbinden des ersten Steuersignals mit dem Regelschalttransistor in der Leistungswandlerschaltungsanordnung;
einen zweiten Gehäusestift, der mit einem Erfassungswiderstand verbindbar ist und mit einer Schaltungsanordnung gekoppelt ist, die innerhalb der Steuervorrichtung integriert ist, um eine Spannung über den Spannungswiderstand zu erfassen, wenn der Regelschalttransistor eingeschaltet ist, wobei der Erfassungswiderstand in einem Strompfad platziert ist, wobei der Strompfad leitend ist, wenn der Regelschalttransistor eingeschaltet ist, und ansonsten nichtleitend ist;
ein Mittel zum Erzeugen eines zweiten Steuersignals; und
ein Mittel zum Koppeln des zweiten Steuersignals mit dem zweiten Gehäusestift, wenn der Regelschalttransistor ausgeschaltet ist.

2. Leistungswandlersteuerung nach Anspruch 1, und wobei das zweite Steuersignal ein Steuersignal für einen Synchrongleichrichter ist.

3. Leistungswandlersteuerung nach einem vorhergehenden Anspruch, und wobei sich das zweite Steuersignal auf einem erhöhten Spannungspegel befindet, der ausreicht, um einen Optokoppler einzuschalten, wobei die erfasste Spannung dafür nicht ausreicht.

4. Leistungswandlersteuerung nach einem vorhergehenden Anspruch, die dazu eingerichtet ist, eine Spannung über den Widerstand zu erfassen, der mit dem zweiten Gehäusestift verbunden ist, wenn das zweite Steuersignal mit dem zweiten Gehäusestift gekoppelt ist.

5. Leistungswandler, der im Wesentlichen sowie unter Bezugnahme auf die Zeichnungen beschrieben ist.

## Revendications

1. Dispositif contrôleur de convertisseur de puissance formé comme un circuit intégré en boîtier, le dispositif comportant :
un moyen pour générer un premier signal de commande pour contrôler un temps d'allumage d'un transistor de commutation de régulation ;
une première broche de boîtier destinée à raccorder le premier signal de commande au transistor de commutation de régulation dans le circuit convertisseur de puissance ;
une deuxième broche de boîtier raccordable à une résistance de détection et couplée à un circuit intégré à l'intérieur du dispositif contrôleur pour détecter une tension aux bornes de la résistance de détection quand le transistor de commutation de régulation est allumé, la résistance de détection étant placée sur un chemin de courant, le chemin de courant étant conducteur quand le transistor de commutation de régulation est allumé et non conducteur autrement ;
un moyen pour générer un deuxième signal de commande ; et
un moyen pour coupler le deuxième signal de commande à la deuxième broche de boîtier quand le transistor de commutation de régulation est éteint.

2. Contrôleur de convertisseur de puissance selon la revendication 1 et dans lequel le deuxième signal de commande est un signal de commande pour un redresseur synchrone.

3. Contrôleur de convertisseur de puissance selon une quelconque revendication précédente et dans lequel le deuxième signal de commande est à un niveau de tension élevé suffisant pour activer un optocoupleur, la tension détectée étant insuffisante pour le faire.

4. Contrôleur de convertisseur de puissance selon une quelconque revendication précédente et étant adapté pour détecter une tension aux bornes d'une résistance raccordée à la deuxième broche de boîtier quand le deuxième signal de commande est couplé à la deuxième broche de boîtier.

5. Convertisseur de puissance sensiblement tel que décrit dans les présentes par renvoi aux dessins.
